# EUROPEAN PATENT SPECIFICATION

(11) **EP 3 561 376 B1**
(45) Date of publication and mention of the grant of the patent: **10.06.2020**
(21) Application number: 19169419.9
(22) Date of filing: 16.04.2019
(51) Int. Cl.: F21V 3/00, F21K 9/61, F21V 8/00, F21Y 103/10, F21Y 115/10, F21S 8/04, F21V 5/02

(54) **OPTICAL ELEMENT FOR DISTRIBUTING LIGHT**
OPTISCHES ELEMENT ZUR VERTEILUNG VON LICHT
ÉLÉMENT OPTIQUE DE DISTRIBUTION DE LUMIÈRE

(30) Priority: 27.04.2018 GB 201807296
(43) Date of publication of application: 30.10.2019
(73) Proprietor: Thorn Lighting Ltd, Siebnen, Durham 8854 (GB)
(72) Inventor: KEANE, Raymond, Spennymoor DL16 7TU (GB)
(74) Representative: Thun, Clemens

(56) References cited:
- US-A1- 2005 111 235
- US-A1- 2014 347 885
- US-A1- 2017 242 177

## Description

The present invention relates to a luminaire comprising a system comprising an optical element, which is used for distributing the light emitted by a longitudinal light source. The longitudinal light source can be formed in particular by a longitudinal arrangement of multiple LEDs.

Currently, light extraction systems are used to distribute the light emitted by a plurality of point like light sources, i.e. LEDs. These known light extraction systems comprise for example a cylindrical pipe or a flat panel type of light guide and extraction. These optical elements, which are made from a transparent material, direct light from a light entry region by total internal reflection and/or refraction to surface areas where the light is then emitted.

The most commonly used light extraction system comprises a flat panel type of light guide where the light emitted by a plurality of LEDs is introduced via one of the side surfaces of the panel. By means of total internal reflection, the light is distributed over the whole panel and finally emitted via at least one of the flat panel surfaces. In this way, a homogenous light emission over a relatively large surface area can be obtained.

In other application fields, however, emitting the light via a flat panel is not desired but the light should be emitted via a specific surface area of a luminaire. In cases where it is not possible to arrange the light sources close to the area where the light is to be emitted, again optical systems are required which can be used to direct or transport the light from the light sources to the light emission area of the luminaire. Here, often specific lenses or lens-like structures are used which redirect the light emitted by the light sources to the area where light emission is desired. Examples for such lens-like structures are disclosed in US 2007/0104963 A1 or US 2012/0140461 A1. In both cases, the lenses have very specific structures wherein the light is redirected via total internal reflection into specific directions pointing towards the area of the luminaire where finally the light is emitted.

In US 2014/0347885 A1 a luminaire is described comprising a waveguide body including a central section and first and second separate side sections extending away from the central section along first and second opposed directions, respectively. The central section includes a coupling portion and the waveguide body has a length and includes a plurality of light extraction features that extract light out of the side sections. At least one LED is disposed adjacent the coupling portion and is operated by a power circuit to produce light that is directed into the waveguide body by the coupling portion. At least one structural member extends along the length of the waveguide body for supporting the waveguide body and encloses at least one of the power circuit and the at least one LED.

In US 2017/0242177 A1 a light fixture configured to mount on a suspended ceiling grid is described, comprising a light guide configured for the transmission of light through total internal reflection, whereby the light guide comprises a central section configured for coupling with one or more light sources and a planar section on each side of the central region, wherein each planar section is oriented substantially perpendicular to the central region, and each planar section is connected to the central section through a curved section.

Starting from this prior art, it is an object of the present invention to provide a luminaire comprising a system comprising an optical element usable for distributing the light emitted by a longitudinal light source wherein the optical element allows to exactly control the transmission of the light to specific light emission areas for example of a luminaire. Furthermore, it is an object of the present invention to provide an optical element, which can be easily manufactured.

The above problem is solved by a luminaire comprising a system comprising an optical element for distributing the light emitted by a longitudinal light source having the features defined in claim 1. Preferred embodiments of the inventive luminaire comprising a system comprising an optical element are subject matter of the dependent claims.

The present invention provides a luminaire comprising a system comprising an optical element, which transports light from a light source to a specific point in a luminaire and supplies the light in a way to allow a secondary optic to be used to best effect. It also allows to avoid unwanted images of the point like light sources on a secondary diffusor while still allowing - if desired - a small proportion of the light from the light source to be used to give an overall lit appearance within the luminaire.

These advantages are achieved by providing a luminaire comprising a system comprising an optical element, which is made from a transparent material and extends along a longitudinal axis wherein the optical element comprises a light insert portion being adapted to receive light emitted by the light source and at least two transport limbs connected to the light insert portion and guiding light received from the light insert portion by total internal reflection to a respective end portion for emitting the light. According to the present invention, the light insert portion is connected to the at least two transport limbs via a single light guiding portion allowing for mixing the light before entering the transport limbs. Accordingly, the light emitted by the longitudinal light source is mixed before it is distributed into different transport paths. This mixing allows for small errors in the position of the light source in relation to the light insert portion of the optical element. The mixing of the light also provides advantages in case LEDs are used to form the longitudinal light source since a more homogenous light emission can be obtained.

Accordingly, the present invention provides a luminaire comprising a system comprising
(a) a longitudinal light source, and
(b) an optical element for distributing the light emitted by a longitudinal light source, said optical element being made of a transparent material and extending along a longitudinal axis, wherein the optical element has:
   - a light insert portion being adapted to receive light emitted by the light source; and
   - at least two transport limbs connected to the light insert portion and guiding the light received from the light insert portion by total internal reflection to a respective end portion for emitting the light;
   wherein the light insert portion is connected to the at least two transport limbs via a single light guiding portion allowing for mixing the light before entering the transport limbs, and
(c) a transparent light emission element forming an interior cavity in which the optical element is arranged, and
(d) a carrier having a mount surface for the light source and being adapted to hold the optical element,
said carrier being adapted to hold an end portion of the light emission element.

Preferably, the light insert portion comprises a longitudinal cavity for receiving the light source. This specific structure of the light insert portion also guarantees that the optical element is correctly positioned over the light source. Further, it is ensured that basically all light emitted by the light source indeed enters the optical element and thus can be used for a controlled light emission defined by the optical element.

Further preferably, the end portions of the at least two transport limbs can have a flared configuration. While preferably the transport limbs have a generally constant thickness over the light transmission path, the flared configuration of the end portion where the light is finally emitted allows for a better controlling of the light emission. Here, the light is preferably emitted via sidewalls of the transport limbs wherein according to a further preferred embodiment of the present invention these sidewalls are curved and/or have a facetted structure.

Preferably, the single light guiding portion splits at an end region opposite to the light insert portion into the at least two transport limbs. The number of transport limbs is, however, not limited to two and the optical element according to the present invention can have three or even more transport limbs. In particular, it is also possible that one of the transport limbs splits into several transport limbs.

The optical element according to the present invention can be symmetrical with respect to a central plane. However, also asymmetric configurations are possible.

Preferably, the at least two transport limbs are integrally formed with the single light guiding portion and the light insert portion. In particular, the optical element can be manufactured by extrusion resulting in low manufacturing costs but also in a rigid structure of the optical element.

Preferably, the light source comprises at least one longitudinal carrier element with LEDs wherein the carrier element is in particular a printed circuit board (PCB). This carrier element with the LEDs is then arranged in the cavity of the light insert portion. According to a preferred embodiment, in the luminaire of the present invention, the carrier can comprise a snap-fit structure for holding the optical element wherein the light source is then arranged between the carrier and the optical element. In such a configuration, the optical element preferably provides a compressive force against the light source. In this way, a correct position of the light source with respect to the optical element is obtained and the transmission of heat generated by the light source to the carrier is improved.

In the luminaire according to the present invention, at least a surface portion of the light emission element can comprise a light influencing structure, in particular a micro lens structure or a micro prism structure wherein the optical element is used to direct the light emitted by the light source to the specific surface portions of the light emission element such that the light can be emitted by the luminaire via the light influencing structure.

In the following, the present invention is explained in more detail with reference to the enclosed drawings.
- Figure 1: illustrates an isometric view of a first embodiment of the optical element of the inventive luminaire.
- Figure 2: is a cross-sectional view of a luminaire comprising the optical element of the inventive luminaire.
- Figure 3: illustrates an enlarged view of a side portion of the luminaire of figure 2 showing the emission of light of the optical element and the further emission via a secondary optics of the luminaire.
- Figure 4: is an enlarged cross-sectional view of an end portion of a transport limb of the optical element.
- Figures 5a and 5b: illustrate the transport of light in an end portion of an optical element according to the present invention wherein the end portion has a constant thickness in figure 5a and a more preferred flared configuration in figure 5b.
- Figure 6: is a further cross-sectional view of the first embodiment of the optical element of the inventive luminaire.
- Figures 7 to 11: show further embodiments of optical elements of the luminaire according to the present invention.
- Figures 12a to 12c: show different alternatives for the end portion of the single light guiding portion splitting into two transport limbs.

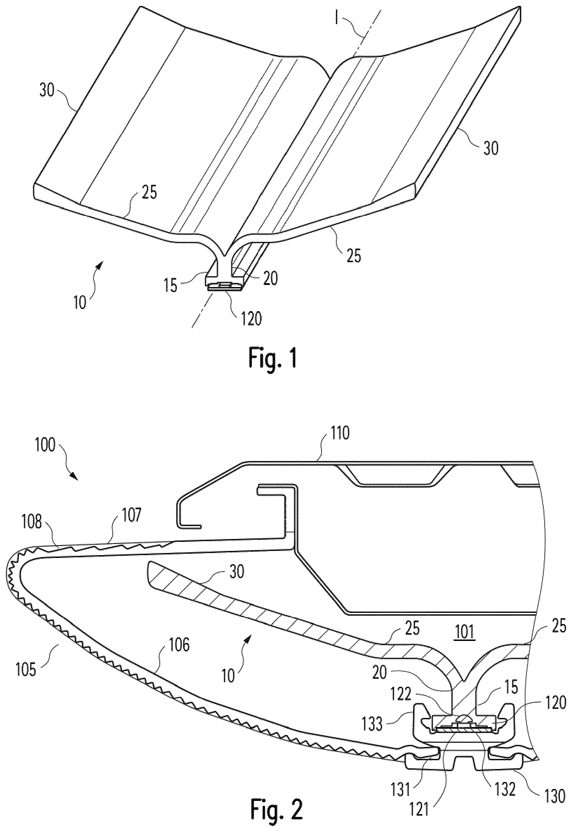

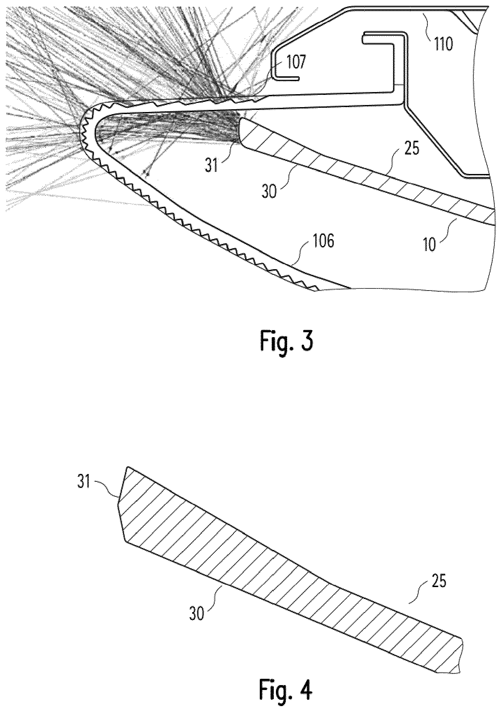

Figure 1 shows a first embodiment of the optical element 10 of the inventive luminaire wherein figures 2 and 3 show in more detail in which way the optical element 10 can be used to support the light emission of longitudinal luminaire 100. In figures 2 and 3, the luminaire 100 is shown in a cross-sectional view wherein the figures show a so called "ceiling mounted luminaire" having a support structure 110 adapted to be mounted to the surface of a ceiling. However, the optical element of the luminaire according to the present invention can be used in a very flexible way and is not restricted to a specific type of luminaires. In particular, the optical element 10 of the inventive luminaire always provides advantages in case light generated by a small light source is to be transferred to specific regions of a luminaire where the light is finally emitted.

As shown in figures 2 and 3, the light source of luminaire 100 is a longitudinal light source 120 formed by a longitudinal printed circuit board 121 having arranged thereon a plurality of LEDs 122. The light source 120 is in the present case arranged in a central lower region of the luminaire 100 as shown in figures 2 and 3 wherein the LEDs 122 face towards an interior cavity 101 of the luminaire 100, which is in particular formed or surrounded by two secondary optics 105 arranged on both sides of the light source 120. Both secondary optics 105 are formed from a transparent material and form the outer transparent surface of the luminaire 100. The secondary optics 105 have - in a cross-sectional view - a curved configuration with a lower portion 106 extending outwardly from the light source 120 and an upper portion 107 running back to the support structure 110.

Mounting of secondary optics 105, light source 120 and the optical element 10 is achieved with the help of a central carrier 130. This central carrier 130 can be made from metal, e.g. aluminum and forms a longitudinal profile with a length corresponding approximately to the length of the luminaire 100. As can be seen from Figure 2, the profile of the central carrier 130 at first comprises longitudinal notches 131 receiving the inner edges of the lower portions 106 of the two secondary optics 105. The central carrier 130 further provides a flat mount surface 132 on which the light source 120 rests. Longitudinal side walls 133 extend on both sides of the mount surface 132, which side walls 133 form a longitudinal channel in which the light source 120 and also a light insert portion 15 of the optical element 10 is received. These side walls 133 further have a snap fit configuration cooperating with the optical element 10 such that optical element 10 is secured to the central carrier 130. In this configuration, the optical element 10 further provides a downwardly directed force to the light source 120 ensuring an enhanced thermal contact between light source 120 and carrier 130. In this way, at least a part of the heat generated by the LEDs 122 during operation of the luminaire 100 can be transferred to the carrier 130, which thus also has the function of a cooling element.

As shown in figure 3 in more detail, it is desired to emit the light generated by the light source 120 in particular via the upper portion 107 of the secondary optics 105 to provide a so-called "indirect illumination". Accordingly, the light is to be emitted into a region on both sides of the luminaire 100 to illuminate parts of the ceiling surrounding the luminaire 100. Although not shown in the figures, additional light sources can be provided within the luminaire 100, which are used for a direct illumination. The light of these additional light sources is then preferably emitted via the lower portion 106 of secondary optics 105.

As can be further seen from figures 2 and 3, secondary optics 105 comprises a light influencing structure on its outer surface in order to better control the emission of the light. This light influencing structure 108 can be formed by an arrangement of micro lenses or micro prism as they are well known in the prior art. Nevertheless, efficiency of this light influencing structure 108 is improved in case the light is internally directed onto the secondary optics 105 over a desired area and within a desired range of angles. The optical element 10 helps to transmit and emit the light emitted by the light source 120 in such a way that both conditions are met. As shown in figure 3, almost all light transmitted via optical element 10 exits the luminaire 100 via the upper portion 107 of secondary optics 105 and strikes internally the secondary optics 105 at angles allowing using this light for an indirect illumination. In the following, the structure of the optical element 10 will be discussed in more detail.

The optical element 10 uses total internal reflection and light refraction properties of a parallel-sided piece of clear material. Accordingly, optical element 10 is made from a suitable clear material, which includes but is not limited to PMMA, PC or silicone. Due to the use in connection with a longitudinal light source, optical element 10 also has a longitudinal configuration and preferably is translation invariant along longitudinal axis I which is shown in figure 1. This allows to manufacture optical element 10 by extrusion resulting not only in a rigid structure but also to manufacture optical element 10 easily at different lengths. Of course, also other methods for manufacturing the optical element 10 could be used.

The basic idea of the optical element 10 is to collect the light emitted by light source 120, mix the light, then distribute, and transport it to the regions within the luminaire 100 where light emission is desired. Accordingly, optical element 10 comprises basically three portions which preferably are integrally connected which each other to form optical element 10.

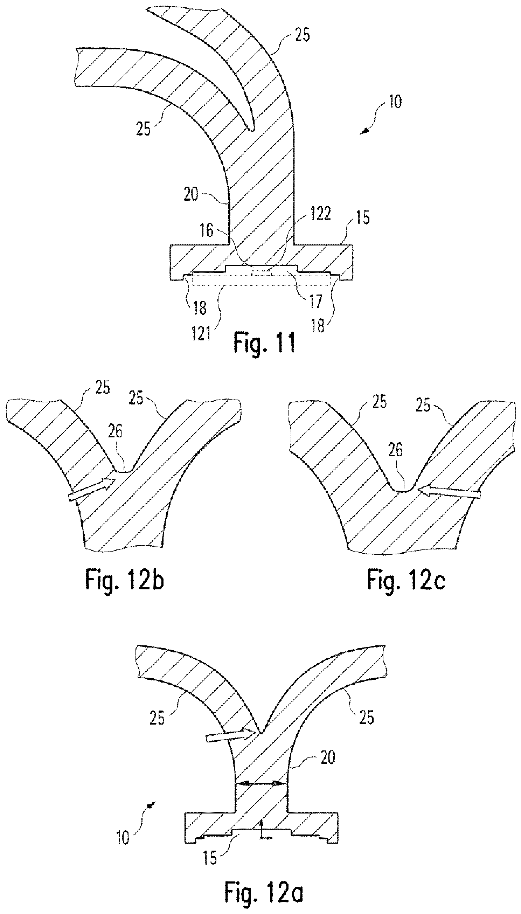

At first, optical element 10 comprises a light insert portion 15 being adapted to gather or receive the light emitted by the light source 120. As can be seen from the isometric view in figure 1, this light insert portion 15 has a longitudinal flat configuration with a light entry surface 16 facing towards the light source 120. As can be seen more clearly in the enlarged view of figure 11, light insert portion 15 preferably has a longitudinal cavity 17 for receiving the LEDs 122 wherein the bottom portion of this cavity 17 forms the light entry surface 16. As shown further in figure 11, this cavity 17 has a stepped - or alternatively a concave - configuration resulting in outer portions 18 receiving the edges of printed circuit board 121. In this way, correct alignment between light source 120 and the light insert portion 15 of optical element 10 is obtained. Further, since the LEDs 122 are located within the cavity 17, almost all light emitted by the LEDs 122 enters the optical element 10 and thus the overall efficiency of the optical system is increased.

Following the light insert portion 15, optical element 10 comprises a single light guiding portion 20, which receives all light entering optical element 10. This single light guiding portion 20 has a width of approximately 5 mm and a height of around 8 mm. It is essential to the present invention that this single light guiding portion 20 has a minimum height of around 3 mm as most of the light should be redirected by total internal reflection at least once before leaving this light guiding portion 20. In this way, the light is mixed and also minor differences in the positioning of the LEDs 122 with respect to the optical element 10 are compensated. Thus, a more homogenous light is provided at an upper end portion of light guiding portion 20 resulting finally in a more homogeneous overall light emission.

At its upper end, i.e. at the end region opposite to the light insert portion 15, the single light guiding portion 20 splits into a plurality of transport limbs 25, in the first embodiment shown into two transport limbs 25. These transport limbs 25 are made up of combinations of curved and straight sections and use total internal reflection to guide the light to respective end portions 30 where the light finally exits the optical element 10 and is further emitted via secondary optics 105. Basically all light entering the optical element 10 and being mixed by light guiding portion 20 is transmitted into the transport limbs 25 although a minor part of the light can be used for a diffuse illumination of the luminaire 100 by adapting the splitting portion. This aspect will be explained later with respect to figures 12a to 12c. Nevertheless, besides this light leak at the splitting portion(s), all other light will be forwarded to the end regions 30 of the transport limbs 25.

The thickness of transport limbs 25 can be up to 5 mm. This in turn defines the radius of any turning sections or split points. The outer radius is a minimum of four times and the inner radius is a minimum of three times the thickness of the limb 25. Both sides of a transport limb 25 should be - with the exception of the end portions 30 - parallel in order to allow for an efficient transport of the light to the end portions 30.

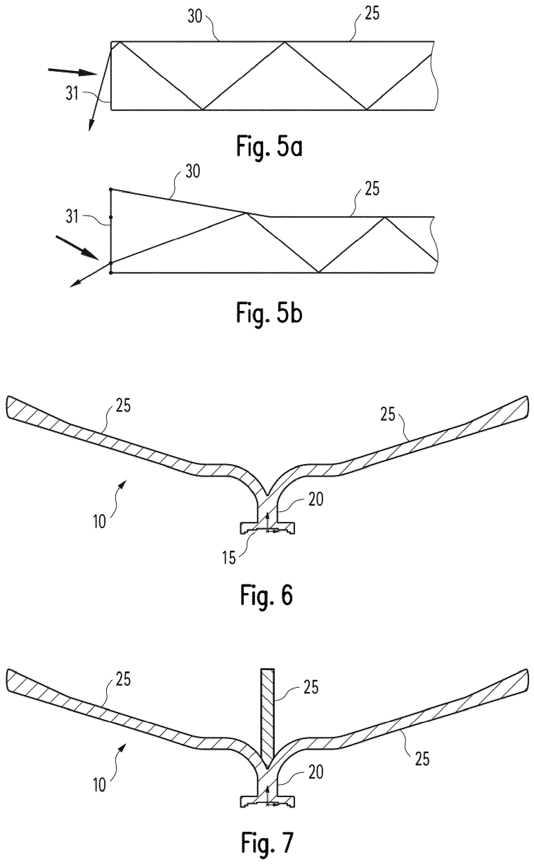

Figures 4, 5a and 5b provide a closer look at the end region 30 of a transport limb 25 showing at first that light is finally emitted via side surfaces 31 of the transport limbs 25. The side surface 31 is not necessarily a flat surface but can have an angled structure as it is shown in figure 4. Also a - concavely of convexly - curved configuration or a facetted structure of this light emission surface 31 would be possible. In this way, directing the light onto specific surfaces or into specific directions can be further improved.

The light directing function of the light emission surface 31 is further supported by a specific configuration of the end portion 30 of transport limb 25. In particular, this end portion 30 preferably has a flared configuration, which means that one of both surfaces of limb 25 - which usually are parallel to each other - slightly diverges from the other surface over the last millimeters of the transport limb 25. The reason for choosing this specific configuration can be seen in figures 5a and 5b showing the path of an exemplary light ray in the end portion 30 of a transport limb 25.

Whereas in the configuration shown in figure 5a - in which both surfaces extend strictly parallel up to the light exit surface 31 - light can exit from the transport limb 25 under relatively large angles with respect to the surface normal of side surface 31, the flared configuration shown in figure 5b helps to influence the light rays in such a way that the exit angle is reduced. This on the other hand allows to better control the light via the structure and/or orientation of the light exit surface 31 and therefore the quality of the light emission is increased. Accordingly, the optical element 10 of the present invention not only allows to transport the light within a luminaire to a specific region where light emission is desired but also allows to control the direction into which the light is finally emitted.

Up to now, the structure and functionality of the optical element 10 has been explained with respect to the first specific embodiment which is shown in figures 1 to 6 and wherein the single light guiding portion 20 splits into two transport limbs 25. However, other configurations of the optical element 10 are also possible as shown in figures 7 to 11.

For example, the single light guiding portion 20 could also split into three transport limbs 25 as it is shown in figure 7 wherein one further additional transport limb 25 continues upwardly following the direction of the light guiding portion 20. Depending on the structure of the luminaire in which this optical element is used, this additional transport limb 25 could be used for example to direct light in a region directly above the luminaire. Such a light emission would be desirable in case the luminaire is a suspended luminaire being arranged at a specific distance below the ceiling. This additional vertical transport limb 25 could be formed by a separate transparent element but is more preferably integrally connected to the other elements forming in combination optical element 10.

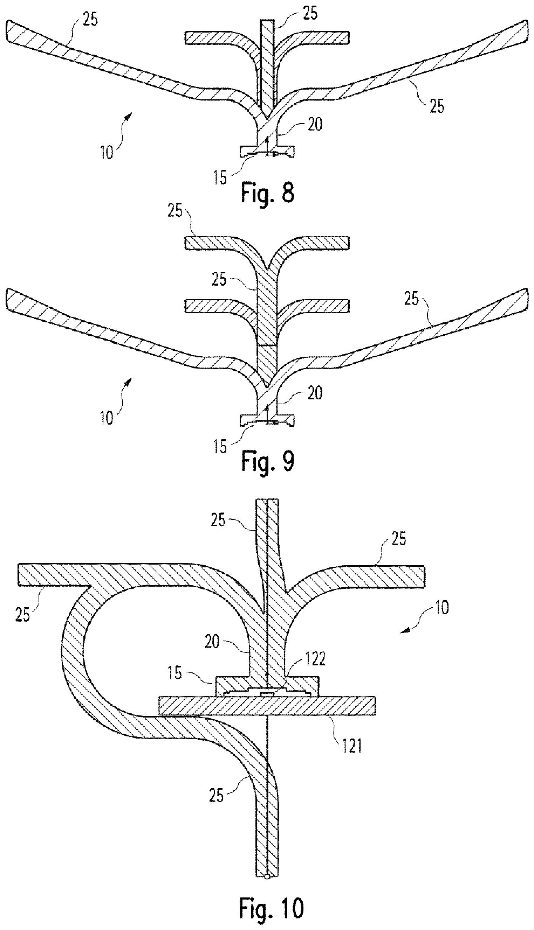

Further, it is also possible that at least one of the transport limbs 25 in a region away from the single light guiding portion 20 further splits into additional "sub limbs". Examples for such a configuration are shown in figures 8 and 9 wherein the vertical transport limb 25 branches once (figure 8) or twice (figure 9) off in several transport sub-limbs 25. Although not shown in the figures, also these sub-limbs could have end portions having a flared configuration similar to the one which is shown in figure 4.

A further specific embodiment of an optical element is shown in figure 10. Here, the light guiding portion 20 and the transport limbs 25 split several times to finally form four transport limbs 25, which extend into four different directions. In this way, a light emitting structure can be realized which has a longitudinal configuration and emits light into all directions. Figure 10 in particular shows that the present invention allows to emit light underneath the PCB 121 that the LEDs 122 are mounted, i.e. in a direction opposite to the original light emission of the LEDs 122. Basically, light can be transported and emitted at any point around the axis perpendicular to the cross-section of the optical element 10. Further, the optical element 10 according to the present invention does not necessarily have a symmetric configuration and also asymmetric structures are possible as it is shown in the example of figure 11

Obviously, the amount of light inserted into the transport limbs 25 emerging from the light guiding portion 20 or a splitting point of a transport limb 25 depends on the ratio of the thickness of the respective transport limbs 25. In this way, it is also possible to control the amount of light which is finally emitted via the different end portions of the transport limbs by varying the thickness of the transport limbs 25 relative to each other.

It is, however, to be noted that the design of the optical element 10 also allows to adapt the regions in which the single light guiding portion 20 or a transport limb 25 splits in such a way that a minor amount of light is allowed to exit the optical element 10 directly at the splitting region. This is shown in figures 12a to 12c showing three different configurations of the splitting region.

In the embodiment shown in figure 12a, the curved parts of the transport limbs 25 are separated by a V-shaped area and both transport limbs 25 tangentially combine into the light guiding portion 20. Here, nearly all light is transmitted into the two transport limbs 25. On the other hand, figures 12b and 12c show alternative solutions for realizing the splitting region wherein both transport limbs are connected by a flat or concavely formed connecting section 26. While in the configuration shown in figure 12a all light transported by the light guiding portion 20 is forwarded into the two transport limbs 25, the embodiments shown in figures 12b and 12c allow a minor amount of light to exit the optical element in the splitting region via the connecting section 26. Depending on the size and/or form of the connecting section 26, it is possible to determine how much light will be emitted at that point. This small amount of light can then be used for example to slightly illuminate the interior cavity of the luminaire allowing to generate interesting illumination effects.

Accordingly, the present invention allows to transport light from a light source to a specific point in a luminaire and supply the light in a way to allow a secondary optics to be used to best effect. The invention also avoids unwanted images of the individual light sources on a secondary diffusor while still allowing a proportion of the light from the source to be used to give an overall lit appearance within the luminaire. The optical element can be provided in very different shapes and could also be used to allow light from below a gear tray to be transported to above the gear tray. Thus, significant advantages are obtained compared to solutions none in the prior art.

## Claims

1. Luminaire (100) comprising a system for generating and emitting light, the system comprising
(a) a longitudinal light source (120), and
(b) an optical element (10) for distributing the light emitted by the longitudinal light source (120),
said optical element (10) being made of a transparent material and extending along a longitudinal axis (I), the optical element (10) having:
• a light insert portion (15) being adapted to receive light emitted by the light source (120); and
• at least two transport limbs (25) connected to the light insert portion (15) and guiding light received from the light insert portion (15) by total internal reflection to an respective end portion (30) for emitting the light,
wherein the light insert portion (15) is connected to the at least two transport limbs (25) via a single light guiding portion (20) allowing for mixing the light before entering the transport limbs (25), **characterised by**
(c) a transparent light emission element (105) forming an interior cavity in which the optical element (10) is arranged, and
(d) a carrier (130) having a mount surface (132) for the light source (120) and being adapted to hold the optical element (10),
said carrier (130) being adapted to hold an end portion of the light emission element (105).

2. Luminaire according to claim 1,
wherein the light insert portion (15) comprises a longitudinal cavity (17) for receiving the light source (120).

3. Luminaire according to claim 1 or 2,
wherein the end portion (30) of at least one of the transport limbs (25) has a flared configuration.

4. Luminaire according to one of claims 1 to 3,
wherein the at least two transport limbs (25) have at their end portions side surfaces (31) for emitting the light.

5. Luminaire according to claim 4,
wherein the side surfaces (31) are curved and/or have a facetted structure.

6. Luminaire according to one of claims 1 to 5,
wherein the single light guiding portion (20) splits in an end region opposite to the light insert portion (15) into the at least two transport limbs (25).

7. Luminaire according to one of claims 1 to 6,
wherein at least one of the transport limbs (25) splits further into additional transport limbs (25).

8. Luminaire according to one of claims 1 to 7,
wherein the optical element (10) is symmetrical with respect to a central plane.

9. Luminaire according to one of claims 1 to 8,
wherein the at least two transport limbs (25) are integrally formed with the single light guiding portion (20) and the light insert portion (15).

10. Luminaire according to claim 9,
wherein the optical element (10) is manufactured by extrusion.

11. Luminaire according to claim 10,
wherein the light source (120) comprises at least one longitudinal carrier element (121) with LEDs (122), said carrier element (121) being in particular a PCB.

12. Luminaire according to claim 11,
wherein the carrier element (121) is arranged in the cavity (17) of the light insert portion (15).

13. Luminaire according to claim 12,
wherein the carrier (130) comprises a snap-fit structure for holding the optical element (10) and wherein the light source (120) is arranged between the carrier (130) and the optical element (10).

14. Luminaire according to claim 13,
wherein the optical element (10) provides a compressive force against the light source (120).

15. Luminaire according to one of the claims 1 to 14,
wherein at least a surface portion (107) of the light emission element (105) comprises a light influencing structure (108), in particular a micro lens structure or a micro prism structure.

## Patentansprüche

1. Beleuchtungskörper (100), umfassend ein System zum Erzeugen und Emittieren von Licht, wobei das System Folgendes umfasst:
(a) eine längliche Lichtquelle (120), und
(b) ein optisches Element (10) zum Verteilen des von der länglichen Lichtquelle (120) emittierten Lichts,
wobei das optische Element (10) aus transparentem Material hergestellt ist und sich entlang einer Längsachse (I) erstreckt, wobei das optische Element (10) Folgendes aufweist:
• einen Lichteintrittsabschnitt (15), der ausgelegt ist, von der Lichtquelle (120) emittiertes Licht zu empfangen; und
• mindestens zwei Transportschenkel (25), die mit dem Lichteintrittsabschnitt (15) verbunden sind und von dem Lichteinrittsabschnitt (15) empfangenes Licht durch innere Totalreflexion zu einem jeweiligen Endabschnitt (30) zum Emittieren des Lichts leiten,
wobei der Lichteintrittsabschnitt (15) mit den mindestens zwei Transportschenkeln (25) über einen einzelnen lichtleitenden Abschnitt (20) verbunden ist, der ein Mischen des Lichts vor dem Eintritt in die Transportschenkel (25) ermöglicht, **gekennzeichnet durch**
(c) ein transparentes Lichtemissionselement (105), das einen inneren Hohlraum bildet, in dem das optische Element (10) angeordnet ist, und
(d) einen Träger (130), der eine Montagefläche (132) für die Lichtquelle (120) aufweist und ausgelegt ist, das optische Element (10) zu halten,
wobei der Träger (130) ausgelegt ist, einen Endabschnitt des Lichtemissionselements (105) zu halten.

2. Beleuchtungskörper nach Anspruch 1,
wobei der Lichteintrittsabschnitt (15) einen länglichen Hohlraum (17) zur Aufnahme der Lichtquelle (120) aufweist.

3. Beleuchtungskörper nach Anspruch 1 oder 2,
wobei der Endabschnitt (30) von mindestens einem der Transportschenkel (25) eine aufgeweitete Ausgestaltung aufweist.

4. Beleuchtungskörper nach einem der Ansprüche 1 bis 3, wobei die mindestens zwei Transportschenkel (25) an ihren Endabschnitten Seitenflächen (31) zum Emittieren des Lichts aufweisen.

5. Beleuchtungskörper nach Anspruch 4,
wobei die Seitenflächen (31) gekrümmt sind und/oder eine facettierte Struktur aufweisen.

6. Beleuchtungskörper nach einem der Ansprüche 1 bis 5,
wobei sich der einzelne lichtleitende Abschnitt (20) in einem Endbereich gegenüber dem Lichteintrittsabschnitt (15) in die mindestens zwei Transportschenkel (25) aufspaltet.

7. Beleuchtungskörper nach einem der Ansprüche 1 bis 6,
wobei sich mindestens einer der Transportschenkel (25) weiter in zusätzliche Transportschenkel (25) aufspaltet.

8. Beleuchtungskörper nach einem der Ansprüche 1 bis 7,
wobei das optische Element (10) symmetrisch in Bezug auf eine Mittelebene ist.

9. Beleuchtungskörper nach einem der Ansprüche 1 bis 8,
wobei die mindestens zwei Transportschenkel (25) integral mit dem einzelnen lichtleitenden Abschnitt (20) und dem Lichteintrittsabschnitt (15) ausgebildet sind.

10. Beleuchtungskörper nach Anspruch 9,
wobei das optische Element (10) durch Extrusion hergestellt wird.

11. Beleuchtungskörper nach Anspruch 10,
wobei die Lichtquelle (120) mindestens ein längliches Trägerelement (121) mit LEDs (122) aufweist, wobei das Trägerelement (121) insbesondere eine Leiterplatte ist.

12. Beleuchtungskörper nach Anspruch 11,
wobei das Trägerelement (121) in dem Hohlraum (17) des Lichteintrittsabschnitts (15) angeordnet ist.

13. Beleuchtungskörper nach Anspruch 12, wobei der Träger (130) eine Einraststruktur zum Halten des optischen Elements (10) aufweist und wobei die Lichtquelle (120) zwischen dem Träger (130) und dem optischen Element (10) angeordnet ist.

14. Beleuchtungskörper nach Anspruch 13,
wobei das optische Element (10) eine Druckkraft gegen die Lichtquelle (120) bereitstellt.

15. Beleuchtungskörper nach einem der Ansprüche 1 bis 14,
wobei mindestens ein Flächenabschnitt (107) des Lichtemissionselements (105) eine Lichtbeeinflussungsstruktur (108), insbesondere eine Mikrolinsenstruktur oder eine Mikroprismenstruktur, aufweist.

## Revendications

1. Luminaire (100) comprenant un système de génération et d'émission de lumière, le système comprenant
(a) une source de lumière longitudinale (120), et
(b) un élément optique (10) pour répartir la lumière émise par la source de lumière longitudinale (120),
ledit élément optique (10) étant constitué d'un matériau transparent et s'étendant le long d'un axe longitudinal (I), l'élément optique (10) ayant :
• une partie d'insertion de lumière (15) étant adaptée pour recevoir la lumière émise par la source de lumière (120) ; et
• au moins deux membres de transport (25) reliés à la partie d'insertion de lumière (15) et guidant la lumière reçue de la partie d'insertion de lumière (15) par réflexion interne totale vers une partie d'extrémité respective (30) pour émettre la lumière,
dans lequel la partie d'insertion de la lumière (15) est reliée aux au moins deux membres de transport (25) par une seule partie de guidage de la lumière (20) permettant de mélanger la lumière avant d'entrer dans les membres de transport (25), **caractérisé par** (c) un élément transparent d'émission de lumière (105) formant une cavité intérieure dans laquelle l'élément optique (10) est agencé, et
(d) un support (130) ayant une surface de montage (132) pour la source de lumière (120) et étant adapté pour maintenir l'élément optique (10),
ledit support (130) étant adapté pour maintenir une partie d'extrémité de l'élément d'émission de lumière (105).

2. Luminaire selon la revendication 1,
dans lequel la partie d'insertion de lumière (15) comprend une cavité longitudinale (17) pour la réception de la source de lumière (120) .

3. Luminaire selon la revendication 1 ou 2,
dans lequel la partie d'extrémité (30) d'au moins un des membres de transport (25) a une configuration évasée.

4. Luminaire selon l'une des revendications 1 à 3, dans lequel au moins deux membres de transport (25) présentent leurs surfaces latérales des parties d'extrémité (31) pour émettre la lumière.

5. Luminaire selon la revendication 4,
dans lequel les surfaces latérales (31) sont courbées et/ou ont une structure à facettes.

6. Luminaire selon l'une des revendications 1 à 5,
dans lequel la partie unique de guidage de la lumière (20) se divise dans une zone d'extrémité opposée à la partie d'insertion de la lumière (15) dans au moins deux membres de transport (25).

7. Luminaire selon l'une des revendications 1 à 6,
dans lequel au moins un des membres de transport (25) se sépare davantage de membres de transport supplémentaires (25).

8. Luminaire selon l'une des revendications 1 à 7,
dans lequel l'élément optique (10) est symétrique par rapport à un plan central.

9. Luminaire selon l'une des revendications 1 à 8,
dans lequel les au moins deux membres de transport (25) sont solidairement formés avec la partie unique de guidage de la lumière (20) et la partie d'insertion de la lumière (15).

10. Luminaire selon la revendication 9,
dans lequel l'élément optique (10) est fabriqué par extrusion.

11. Luminaire selon la revendication 10,
dans lequel la source de lumière (120) comprend au moins un élément de support longitudinal (121) avec des LED (122), ledit élément de support (121) étant en particulier un PCB.

12. Luminaire selon la revendication 11,
dans lequel l'élément de support (121) est disposé dans la cavité (17) de la partie d'insertion de la lumière (15).

13. Luminaire selon la revendication 12, dans lequel le support (130) comprend une structure d'ajustement par pression pour maintenir l'élément optique (10) et dans lequel la source de lumière (120) est disposée entre le support (130) et l'élément optique (10).

14. Luminaire selon la revendication 13,
dans lequel l'élément optique (10) fournit une force de compression contre la source de lumière (120).

15. Luminaire selon l'une des revendications 1 à 14,
dans lequel au moins une partie de surface (107) de l'élément d'émission de la lumière (105) comprend une structure influençant la lumière (108), en particulier une structure de micro-lentille ou une structure micro-prisme.
